# EUROPÄISCHE PATENTANMELDUNG

(11) **EP 0 597 412 A1**
(43) Veröffentlichungstag der Anmeldung: **18.05.1994**
(21) Anmeldenummer: 93118041.8
(22) Anmeldetag: 08.11.1993
(51) Int. Cl.: H01J 27/08, H01J 1/02, H01J 9/04

(54) **Drahtwendel-Hohlkatode und Verfahren zu ihrer Herstellung**

(30) Priorität: 10.11.1992 DE 4237849
(71) Anmelder: VTD Vakuumtechnik Dresden GmbH, D-01257 Dresden (DE)
(72) Erfinder: Grimm, Werner, D-01326 Dresden (DE); Cernohorsky, Hagen, D-01159 Dresden (DE); Herrmann, Horst, D-01219 Dresden (DE)
(74) Vertreter: Pätzelt, Peter, Dipl.-Ing. Patentanwalt

(57) **Zusammenfassung**

Die Erfindung betrifft eine Drahtwendel-Hohlkatode, insbesondere zum Einsatz in Hohlkatoden-Bogenverdampfern, sowie ein Verfahren zur Herstellung der erfindungsgemäßen Drahtwendel-Hohlkatode.

Die widerstandsbeheizte Drahtwendel-Hohlkatode besteht aus einer rohrförmig gewickelten Drahtwendel (3), die mindestens im Bereich der aktiven Zone (A) der Drahtwendel-Hohlkatode entlang der Berührungslinie der benachbarten Drahtwindungen versintert und/oder verschweißt ist.

Zur Herstellung einer derartigen Hohlkatode wird ein Verfahren angegeben, bei dem die in bekannter Weise rohrförmig gasdicht gewickelte Drahtwendel (3) in einer Vorrichtung, die die formgerechte Lage der Drahtwendel (3) gewährleistet, durch Widerstandsbeheizung und/oder Fremdbeheizung auf eine Temperatur gebracht wird, bei der die benachbarten Drahtwindungen entlang ihrer Berührungslinie miteinander versintern und/oder verschweißen, und daß während der Erwärmung der Drahtwendel (3) und/oder bei Erreichen der angegebenen Temperatur in der Längsachse der Drahtwendel (3) eine mechanischer Kraft auf diese ausgeübt wird. 1

## Beschreibung

Die Erfindung betrifft eine Drahtwendel-Hohlkatode, insbesondere zum Einsatz in Hohlkatoden-Bogenverdampfern, sowie ein Verfahren zur Herstellung der erfindungsgemäßen Drahtwendel-Hohlkatode.

In der DD 218 818 wird als eine besondere Form der Hohlkatoden eine Drahtwendel-Hohlkatode vorgeschlagen. Diese Hohlkatode besteht aus einem rohrförmigen im wesentlichen gasdichten Drahtwickel aus hochschmelzendem Material, z.B. Wolfram, der jeweils an seinen Enden elektrisch kontaktiert ist. Der besondere Vorteil dieser Drahtwendel-Hohlkatode besteht darin, daß durch Widerstandsbeheizung des Drahtwickels selbst eine sehr wirksame Heizung der Hohlkatode erzielt wird. Obwohl die einzelnen Drahtwendel untereinander durch die im wesentlichen gasdichte Wicklung Berührungskontakt haben und somit auch an den Berührungslinien Strombrücken bestehen, erfolgt der wesentliche Stromfluß über die Querschnittsfläche des Einzeldrahtes. Diese Querschnittsfläche ist wesentlich geringer als der Querschnitt eines einfachen Hohlkatoden-Rohres, so daß der Drahtwickel sehr vorteilhaft bereits bei relativ geringen Strömen bis zur erforderlichen Emissionstemperatur aufgeheizt werden kann, wobei im Bereich der aktiven Zone eine zusätzliche äußere Heizwendel vorhanden sein kann. Beim Einsatz einer derartigen Drahtwendel-Hohlkatode können sich jedoch bei Betriebstemperaturen mechanische Stabilitätsprobleme ergeben. Wenn die Drahtwendel-Hohlkatode schräg oder horizontal angeordnet wird, kann die weiß glühende Hohlkatode relativ leicht seitlich abkippen. Dadurch kommt es zu Undichtigkeiten der "im wesentlichen gasdichten Drahtwickel", d. h. das Arbeitsgas, z. B. Argon, welches durch die Hohlkatode in den Plasmaraum eingelassen wird und als Trägermedium der Bogenentladung dient, weicht seitlich aus der Drahtwendel-Hohlkatode aus. Das wiederum führt zu unerwünschten Beeinflussungen der Parameter der Bogenentladung und in der Folge zu Ungleichmäßigkeiten bei der entsprechenden technologischen Plasmabearbeitung oder plasmagestützten Vakuumbeschichtung von Substraten.

Weiter wurde vorgeschlagen, innerhalb der Drahtwendel-Hohlkatode drei Wolframstäbe und zusätzlich außerhalb der Drahtwendel-Hohlkatode ein gasdichtes Stabilisierungswendel anzuordnen. Damit soll die eigentliche Drahtwendel-Hohlkatode in ihrer Lage stabilisiert werden. Der Bereich der aktiven Zone einer derartigen Hohlkatode bleibt jedoch weiterhin nicht stabilisiert. Die Gefahr des Auftretens von Undichtigkeiten bleibt zumindest in diesem Bereich weiterhin bestehen. Im übrigen ist eine derartige Stabilisierung des Drahtwendels mit einem relativ hohem technischen Aufwand verbunden.

Der Erfindung liegt die Aufgabe zugrunde, eine Drahtwendel-Hohlkatode zu schaffen, die eine hohe Eigenstabilität bei Betriebstemperatur aufweist. Des weiteren besteht die Aufgabe ein Verfahren zur Herstellung der erfindungsgemäßen Drahtwendel-Hohlkatode anzugeben, welches die Herstellung mit minimalem technischen und ökonomischen Aufwand ermöglicht.

Die Erfindung löst die Aufgabe derart, daß die rohrförmig gewickelte Drahtwendel mindestens im Bereich der aktiven Zone der Drahtwendel-Hohlkatode entlang der Berührungslinie der benachbarten Drahtwindungen versintert und/oder verschweißt ist. Im Bereich der Aufnahme der Drahtwendel-Hohlkatode hat es sich als vorteilhaft erwiesen, die einzelnen Drahtwindungen nicht zu versintern und/oder zu verschweißen, damit in diesem Bereich eine relative Elastizität erhalten bleibt.

Die Versinterung bzw. Verschweißung entlang der Berührungslinie der benachbarten Drahtwindungen sichert eine hohe Stabilität der Drahtwendel-Hohlkatode auch bei hohen Betriebstemperaturen von ca. 2500 _{°}C. Der wesentliche Vorteil der Drahtwendel-Hohlkatode, daß der Stromfluß im wesentlichen durch den Querschnitt des Drahtes erfolgt, bleibt erhalten. Der Stromfluß über die versinterte und/oder verschweißte Berührungslinie der benachbarten Drahtwindungen ist zweifellos bei der erfindungsgemäßen Drahtwendel-Hohlkatode höher als in der ursprünglichen Form, jedoch noch wesentlich geringer als bei einer einfachen rohrförmigen Hohlkatode. Bei der vorgeschlagenen Ausführung, daß im Bereich der Aufnahme der Drahtwendel-Hohlkatode die einzelnen Drahtwindungen nicht miteinander versintert und/oder verschweißt werden, ist insofern für die Funktionsweise der Drahtwendel-Hohlkatode unkritisch, da in diesem Bereich niedrigere Temperaturen auftreten und hier die Formstabilität durch die Aufnahme der Drahtwendel-Hohlkatode in einer Bohrung oder auf einem Stutzen gesichert wird. Zugleich verhindert die formschlüssige Aufnahme den seitlichen Gasaustritt. Von Vorteil ist bei einer derartigen Ausführung, daß die vergleichsweise hohe Elastizität der Drahtwendel-Hohlkatode in diesem Bereich eine formschlüssige eng tolerierte Konstruktion der Aufnahme-Verbindung gestattet. Das Auswechseln der Drahtwendel-Hohlkatode kann durch einfaches Auf- bzw. Einstecken erfolgen.

Zur Herstellung der erfindungsgemäßen Drahtwendel-Hohlkatode wird ein Verfahren vorgeschlagen, bei dem die in bekannter Weise rohrförmig dicht gewickelte Drahtwendel in einer Vorrichtung, die die formgerechte Lage der Drahtwendel gewährleistet, durch Widerstandsbeheizung und/oder Fremdbeheizung auf eine Temperatur gebracht wird, bei der die benachbarten Drahtwindungen entlang ihrer Berührungslinie miteinander versintern und/oder verschweißen und daß während der Erwärmung der Drahtwendel und/oder bei Erreichen der angegebenen Temperatur in der Längsachse der Drahtwendel eine mechanischer Kraft auf diese ausgeübt wird. Vorteilhaft ist es, dieses Verfahren unter Vakuum oder unter Schutzgas auszuführen. Die Temperatur des Drahtes, bei dem der Sinterungs- bzw. Schweißeffekt eintritt, liegt beim Einsatz von Wolfram als Material für die Drahtwendel oberhalb von 2500 °C. Als besonders vorteilhaft hat sich die Widerstandsbeheizung des Drahtwendels bewährt. Innerhalb der Vorrichtung werden dabei die beiden Enden des Drahtwendels elektrisch kontaktiert und durch Stromfluß auf die angegebene Temperatur gebracht.

Unter der Einwirkung der mechanischen Kraft in der Längsachse setzt ein nicht eindeutig zu definierender Prozeß der Versinterung und/oder Verschweißung der einzelnen benachbarten Drahtwindungen entlang der Berührungslinie ein.

Die mechanische Kraft auf die Drahtwendel darf dabei nicht dazu führen, daß der einzelne Draht deformiert und flach gedrückt wird. Es wurde gefunden, daß bereits relativ geringe Kräfte ausreichen, um den geschwünschten Versinterungs-und/oder Verschweißungseffekt zu bewirken. Eine derartige Drahtwendel-Hohlkatode weist grob äußerlich betrachtet keinerlei Anzeichen von Verschweißungen auf. Die einzelnen Drahtwindungen scheinen nur eng aneinander zu liegen. Beim Einsatz entsprechender Biegekräfte sind jedoch hohe Festigkeiten des Drahtwendels feststellbar. Bei Prüfungen konnte auch festgestellt werden, daß durch die Windungen kein oder nur in geringem Maße Gas aus dem Inneren der Drahtwendel entweichen kann. Zur Gewährleistung eines elastischen Abschnittes im Bereich der späteren Halterung der Drahtwendel-Hohlkatode wird dieser Bereich der Drahtwendel in der Vorrichtung in einer Aufnahme aufgenommen, die wassergekühlt ist. Damit wird mit relativ einfachen Mitteln gesichert, daß dieser Bereich auch beim Stromdurchgang nicht die erforderlichen Temperaturen zum Versintern bzw. Verschweißen erreicht.

Die Erfindung wird nachfolgend an einem Ausführungsbeispiel näher erläutert werden.

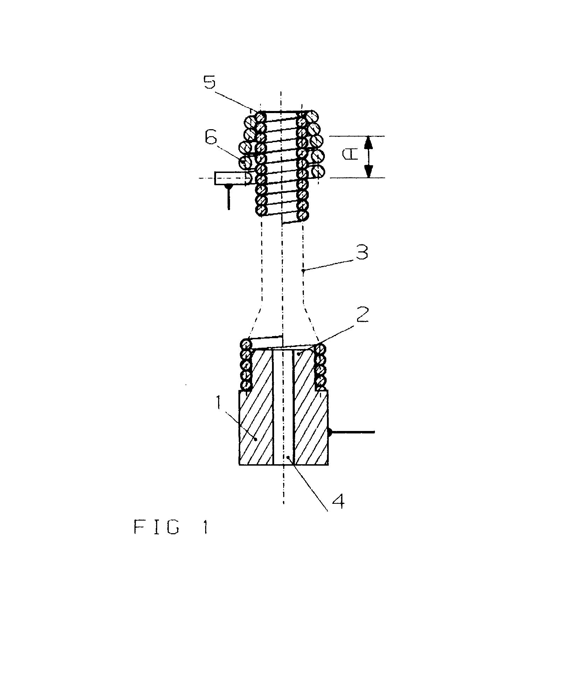

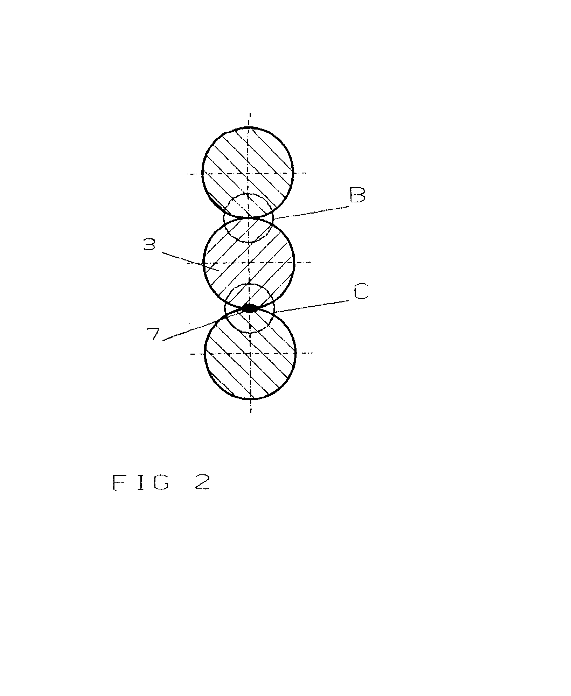

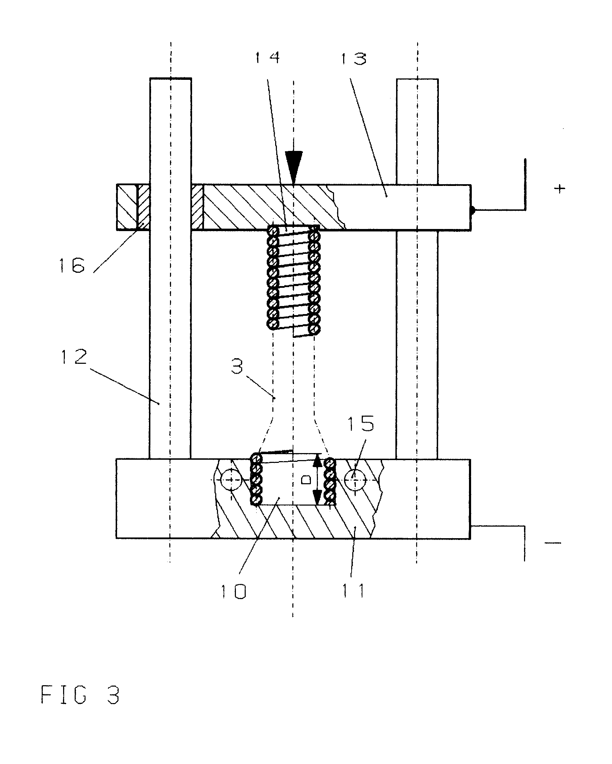

Figur 1 zeigt eine Drahtwendel-Hohlkatode im Schnitt. Figur 2 zeigt einen vergrößerten Ausschnitt einer Drahtwendel-Hohlkatode mit und ohne erfinderischem Merkmal. Figur 3 zeigt eine Vorrichtung zu Realisierung des Verfahrens zur Herstellung der erfindungsgemäßen Drahtwendel-Hohlkatode.

In Figur 1 ist eine in der äußeren Form bekannte Drahtwendel-Hohlkatode dargestellt. Im Beispiel wird zur Unterscheidung die fertige komplette erfindungsgemäße Drahtwendel-Hohlkatode als solche bezeichnet und die Wendel, die unbearbeitet ist bzw. sich in der Herstellung befindet, als Drahtwendel 3.

Auf einer Drahtwendel-Aufnahme 1 ist auf einem Ansatz 2 die Drahtwendel 3 passend aufgesteckt. Über eine Bohrung 4 wird das Arbeitsgas, in der Regel Argon, in die Drahtwendel-Hohlkatode eingelassen. Im Bereich A soll sich beim Einsatz der Drahtwendel-Hohlkatode die aktive Zone ausbilden. Zu diesem Zweck ist am oberen Ende 5 der Drahtwendel 3 eine Heizwendel 6 angeordnet, über welche der Strom für die direkte Widerstandsheizung des Drahtwendels 3 zugeführt wird und das Drahtwendels 3 zusätzlich über Strahlungsheizung erwärmt wird. Das Heizwendel 6 wird auf das obere Ende 5 des Drahtwendels 3 passend aufgeschraubt, so daß eine gute elektrische Kontaktierung erzielt wird.

In Figur 2 ist die Erfindung näher dargestellt. Stark vergrößert zeigt diese einen Abschnitt der Drahtwendel 3 an der Berührungsstelle der nebeneinanderliegenden Drahtwindungen. Der Ausschnitt B zeigt eine Berührungsstelle der Drahtwendel 3 nach dem Stand der Technik. Die einzelnen Windungen des Drahtwendels 3 liegen dicht aneinander, sind aber mechanisch nicht miteinander verbunden. Im Ausschnitt C ist das erfindungsgemäße Merkmal der Drahtwendel-Hohlkatode dargestellt. Zwischen den einzelnen Drahtwindungen des Drahtwendels 3 ist in erfindungsgemäßer Weise eine Sinterungs- und/oder Schweißverbindung 7 ausgebildet. Diese Sinterungs- und/oder Schweißverbindung 7 ist im Querschnitt sehr minimal und konzentriert sich auf den Berührungspunkt der beiden sich berührenden Kreisquerschnitte des Drahtwendels 3. Die Sinterungs- und/oder Schweißverbindung 7 verläuft ununterbrochen entlang der Berührungslinie der einzelnen Drahtwindungen des Drahtwendels 3. Dadurch wird eine kompakte Verbindung mit hoher Stabilität erzielt.

Das Verfahren zur Herstellung der erfindungsgemäßen Drahtwendel-Hohlkatode wird unter Anwendung der Vorrichtung gemäß Figur 3 beispielhaft erläutert. Das Drahtwendel 3, welches in bekannter Weise im wesentlichen rohrförmig dicht gewickelt ist und dessen Enden zur Längsachse rechtwinklig angeschliffen sind, befindet sich in einer Bohrung 10 in einer Grundplatte 11. In zwei Parallelführungen 12 der Vorrichtung ist eine Druckplatte 13 geführt, die eine Ausdrehung 14 aufweist, in der die Drahtwendel 3 formgerecht eingesetzt wird. Die Grundplatte 11 ist im Bereich der Bohrung 10 wassergekühlt, dazu weist sie entsprechende Bohrungen 15 auf. Die Grundplatte 11 und die Druckplatte 13 sind elektrisch kontaktiert und über die Führungen 16 in der Druckplatte 13 zueinander isoliert angeordnet.

Zur Herstellung der erfindungsgemäßen Drahtwendel-Hohlkatode wird die Drahtwendel 3 in die Bohrung 10 und die Ausdrehung 14 eingesetzt, wodurch sie in der Vorrichtung formgerecht gehaltert wird. Gleichzeitig wird mittels einer nicht dargestellte Feder über die Druckplatte 13 auf die Drahtwendel 3 in der Längsachse eine Kraft von ca. 1 N auf die Drahtwendel 3 ausgeübt und aufrechterhalten.

Danach wird der Raum um die Vorrichtung in bekannter Weise evakuiert, damit an der Drahtwendel 3 bei den verfahrensgemäßen hohen Temperaturen keine Oxidations- und/oder Korrosionsprozesse auftreten. In der Folge wird zwischen der Grundplatte 11 und der Druckplatte 13 ein Stromfluß durch die Drahtwendel 3 von ca. 600 A eingestellt. Dabei erwärmt sich die Drahtwendel 3 in kurzer Zeit auf Temperaturen von über 2500 °C. Zwischen den nebeneinander liegenden Drahtwindungen kommt es entlang der Berührungslinie zu Stromüberschlägen und mikroörtlichen Überhitzungen bis an den Schmelzpunkt des Wolfram-Materials. Bereits nach einer kurzen Zeit von weniger als 30 Sekunden ist entlang der Berührungslinie der nebeneinander liegenden Drahtwindungen in einem nicht genau definierbaren Prozeß eine ununterbrochene Versinterungs- und/oder Schweißzone ausgebildet worden, ohne daß der Querschnitt der Einzelwindungen wesentlich verformt wurde. Dieser Prozeß ist während der Heizphase meßtechnisch nachweisbar, indem sich der Spannungsabfall, der über die Enden des Drahtwendels 3 gemessen wird, anfänglich kontinuierlich ansteigt und während der Heizphase plötzlich zu einem kleineren Wert hin verändert. Ausgenommen von diesem Prozeß ist der Bereich D, da dieser durch die Wasserkühlung der Grundplatte 11 auf Temperaturen gehalten wurde, die eine Versinterung und/oder Verschweißung nicht zulassen. Die formgerechte Lagerung der Drahtwendel 3 in der Vorrichtung und die relativ geringen Druckkräfte in der Längsachse des Drahtwendels 3 sichern, daß der Querschnitt der einzelnen Drahtwindungen der Drahtwendel 3, trotz der hohen Temperaturen im wesentlichen unbeeinflußt beibehalten wird.

Mit der Erfindung wird eine Drahtwendel-Hohlkatode geschaffen, die die bekannten energetischen Vorteile der Drahtwendel-Hohlkatoden bei hoher Stabilität aufweist, gasdicht ist und stabile Plasmaparameter sichert. Mit dem erfindungsgemäßen Verfahren können die erfindungsgemäßen Drahtwendel-Hohlkatoden sehr vorteilhaft mit einfachen Mitteln bei technisch und ökonomisch geringem Aufwand hergestellt werden.

## Patentansprüche

1. Widerstandsbeheizte Drahtwendel-Hohlkatode mit einer rohrförmig gewickelten Drahtwendel aus hochschmelzendem Material, dadurch gekennzeichnet, daß die rohrförmig gewickelte Drahtwendel (3), mindestens im Bereich der aktiven Zone (A) der Drahtwendel-Hohlkatode entlang der Berührungslinie der benachbarten Drahtwindungen versintert und/oder verschweißt ist.

2. Widerstandsbeheizte Drahtwendel-Hohlkatode nach Anspruch 1, dadurch gekennzeichnet, daß der Einspannbereich der Drahtwendel-Hohlkatode in die Hohlkatodenhalterung nicht versintert und/oder verschweißt ist.

3. Verfahren zur Herstellung einer widerstandsbeheizten Hohlkatode mit einer rohrförmig gewikkelten Drahtwendel aus hochschmelzendem Material, dadurch gekennzeichnet, daß die in bekannter Weise rohrförmig gasdicht gewikkelte Drahtwendel (3) in einer Vorrichtung, die die formgerechte Lage der Drahtwendel (3) gewährleistet, durch Widerstandsbeheizung und/oder Fremdbeheizung auf eine Temperatur gebracht wird, bei der die benachbarten Drahtwindungen entlang ihrer Berührungslinie miteinander versintern und/oder verschweißen, und daß während der Erwärmung der Drahtwendel (3) und/oder bei Erreichen der angegebenen Temperatur in der Längsachse der Drahtwendel (3) eine mechanischer Kraft auf diese ausgeübt wird.

4. Verfahren nach Anspruch 3, dadurch gekennzeichnet, daß das Ende der Drahtwendel (3), welches beim Einsatz der Drahtwendel-Hohlkatode in der Drahtwendel-Aufnahme (1) gehaltert ist, während der Verfahrensführung gekühlt wird.

5. Verfahren nach Anspruch 3, dadurch gekennzeichnet, daß das Verfahren im Vakuum oder unter Schutzgas durchgeführt wird.
